# EUROPEAN PATENT APPLICATION

(11) **EP 4 481 918 A1**
(43) Date of publication of application: **25.12.2024**
(21) Application number: 24170720.7
(22) Date of filing: 17.04.2024
(51) Int. Cl.: H01M 50/209, H01M 50/519, H01M 50/553, H01M 50/569, H01M 10/42, H01M 50/503

(54) **FASTENING DEVICE AND BATTERY PACK INCLUDING THE SAME**

(30) Priority: 13.06.2023 KR 20230075625
(71) Applicant: Samsung SDI Co., Ltd., Yongin-si, Gyeonggi-do 17084 (KR)
(72) Inventor: Bae, Jin Cheol, 17084 Yongin-si, Gyeonggi-do (KR)
(74) Representative: Gulde & Partner

(57) **Abstract**

A fastening device of a battery pack that fastens an electrical connection between a battery module and a circuit board managing the battery module, the fastening device including a substrate including a plurality of fastening holes, a plurality of connection circuit boards coupled to a surface of the substrate facing the circuit board and electrically connecting the battery module and the circuit board when in contact with the circuit board, and a plurality of fastening hooks fastened to the plurality of fastening holes capable of fixing a position of the substrate so that the plurality of connection circuit boards come into contact with the circuit board, the plurality of connection circuit boards each respectively including a first end portion electrically connected to the battery module, and a second end portion coupled to the substrate and electrically connected to the circuit board when in contact with the circuit board.

## Description

### BACKGROUND

### 1. Field

Embodiments of the present invention relate to a fastening device and a battery pack including the same.

### 2. Description of the Related Art

Secondary batteries are different from primary batteries that provide only irreversible conversion of a chemical material into electrical energy in that charging and discharging may be repeated. Low-capacity secondary batteries are used as power source devices for small electronic devices such as mobile phones, notebook computers, and camcorders, and high-capacity secondary batteries are used as power source devices for electric vehicles, hybrid vehicles, energy storage systems (ESS), and the like.

### SUMMARY

Embodiments of the present invention are directed to a fastening device of a battery pack that fastens an electrical connection between a battery module and a circuit board managing the battery module, the fastening device including a substrate including a plurality of fastening holes, a plurality of connection circuit boards coupled to a surface of the substrate facing the circuit board and electrically connecting the battery module and the circuit board when in contact with the circuit board, and a plurality of fastening hooks fastened to the plurality of fastening holes capable of fixing a position of the substrate so that the plurality of connection circuit boards come into contact with the circuit board, the plurality of connection circuit boards each respectively including a first end portion electrically connected to the battery module, and a second end portion coupled to the substrate and electrically connected to the circuit board when in contact with the circuit board.

In embodiments the second end portion may include a contact pad that contacts a conductive pad of the circuit board if each of the plurality of connection circuit boards contacts the circuit board, and the contact pad may be electrically connected to the first end portion.

In embodiments each of the plurality of connection circuit boards may be a flexible circuit board, and the first end portion may be separated from the substrate.

In embodiments the first end portion may be coupled to a bus bar and electrically connected to the battery module through the bus bar.

In embodiments each of the plurality of fastening hooks may include a fastening post including a first end portion coupled to a fixing structure having a fixed position in the battery pack and a second end portion inserted into a corresponding fastening hole among the plurality of fastening holes, and an elastic hook coupled to an outer surface of the fastening post and having a variable protruding height by pressing.

In embodiments the elastic hook may have a shape with a width that becomes narrower as it approaches the second end portion of the fastening post.

In embodiments the elastic hook may protrude so as not to pass through a corresponding fastening hole in an unpressurized state, and if the substrate is pressed in a state in which the fastening post may be inserted into the corresponding fastening hole, a protrusion height is reduced by a pressure of the substrate, so that the elastic hook passes through the corresponding fastening hole.

In embodiments the elastic hook may operate as a stopper that fixes a position of the substrate in a state in which the plurality of fastening hooks are fastened to each fastening hole.

In embodiments a cylindrical spring surrounding the fastening post may have a diameter greater than that of the plurality of fastening holes.

In embodiments the first end portion of the fastening post may be coupled to a bus bar of the battery pack.

In embodiments the first end portion of the fastening post may be coupled to an upper frame of the battery pack.

In embodiments the substrate may be a transparent substrate.

Embodiments are directed to a battery pack, including the fastening device, a battery module including a plurality of battery cells, and a circuit board on which at least one IC, a plurality of conductive pads, and a power circuit supplying an operation voltage to the at least one IC by using a voltage input through the plurality of conductive pads are mounted.

In embodiments the second end portion of each of the plurality of connection circuit boards may be pressed by the substrate to come into contact with the plurality of conductive pads if the plurality of fastening hooks are fastened to the plurality of fastening holes.

In embodiments the circuit board may include a main board, and a plurality of connection structures providing a flexible connection between the plurality of conductive pads and the main board.

In embodiments the plurality of connection structures may be meander-shaped or spring-like structures formed by removing a portion of an outer portion of a board material composing the circuit board.

### BRIEF DESCRIPTION OF THE DRAWINGS

Features will become apparent to those of skill in the art by describing in detail exemplary embodiments with reference to the attached drawings in which:
FIG. 1 is a schematic configuration diagram of a battery pack according to an embodiment.
FIG. 2 is a schematic diagram of a PCB included in a management device of FIG. 1 according to an embodiment.
FIG. 3 to FIG. 5 are drawings showing a method of fastening or disconnecting an electrical connection between a management device and a battery module using a fastening device according to an embodiment.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art. Like reference numerals refer to like elements throughout.

In the present specification, the term "and/or" includes all or random combinations of a plurality of items that are related and arranged. When the embodiments of the present disclosure are described, the use of "may" signifies "one or more embodiments of the present disclosure". In the following description of an embodiment of the present disclosure, a singular term may include a plural form unless stated in another way. As used herein, the term "or" is not an exclusive term, e.g., "A or B" would include A, B, or A and B

Terms including ordinal numbers such as first, second, third, and the like will be used only to describe various components, and are not to be interpreted as limiting these components. The terms are only used to differentiate one component from other components. For example, a first constituent element could be termed a second constituent element, and similarly, a second constituent element could be termed a first constituent element, without departing from the scope of the present disclosure.

It will be understood that when a constituent element or layer is referred to as being "on," "connected to," or "coupled to" another constituent element or layer, it can be directly on, connected to, or coupled to the other constituent element or layer, or one or more intervening constituent elements or layers may be present. In addition, it will also be understood that when a constituent element or layer is referred to as being "between" two constituent elements or layers, it can be the only constituent element or layer between the two constituent elements or layers, or one or more intervening constituent elements or layers may also be present.

Electrically connecting two constituent elements includes directly connecting two constituent elements, and connecting the same with another constituent element therebetween. The other constituent element may include a switch, a resistor, and a capacitor. When the embodiments are described, an expression of connection signifies electrical connection when an expression of direct connection is not provided.

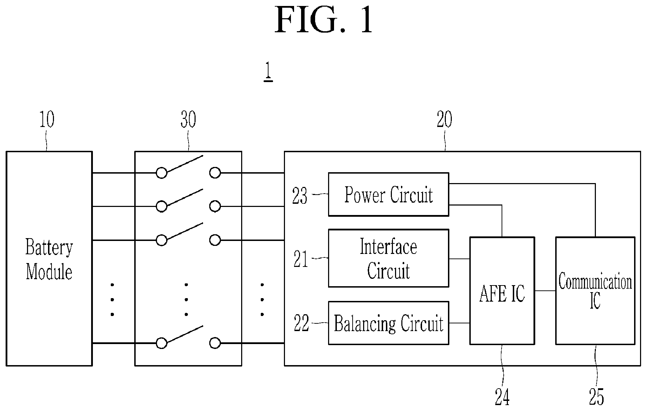

FIG. 1 is schematic configuration diagram of a battery pack according to an embodiment.

Referring to FIG. 1, a battery pack 1 may include a battery module 10, a management device 20, and a fastening device 30.

The battery module 10 may include a plurality of battery cells connected in series and/or in parallel to each other.

The management device 20 may operate as a battery management module (BMM) that performs state, e.g., voltage, current, temperature, and the like, measurement, cell balancing, charging/discharging control, and communication functions for the battery module 10. The management device 20 may include an interface circuit 21, a balancing circuit 22, a power circuit 23, an AFE IC 24, and a communication IC 25.

The interface circuit 21, the balancing circuit 22, and the power circuit 23 may be electrically connected to a plurality of battery cells included in the battery module 10 through the fastening device 30.

The interface circuit 21 may perform a function of transmitting a voltage of the battery cell to the AFE IC 24 so that the AFE IC 24 may detect the cell voltage of the battery cells included in the battery module 10.

The balancing circuit 22 may perform a cell balancing function between battery cells included in the battery module 10 under the control of the AFE IC 24.

The power circuit 23 may be electrically connected to the battery module 10 through the fastening device 30. If the power circuit 23 is electrically connected to the battery module 10, it may supply an operation voltage for operating the management device 20 by using a voltage supplied from the battery module 10. That is, if the module voltage of the battery module 10 is input through the fastening device 30, the power circuit 23 may convert the input module voltage into a voltage required for operation of the AFE IC 24 and the communication IC 25 to output it. In an implementation, if the electrical connection between the power circuit 23 and the fastening device 30 is disconnected by the fastening device 30, the operation voltage supply of the power circuit 23 may be stopped.

The power circuit 23 may additionally perform a reset function of ICs, e.g., the AFE IC 24 and the communication IC 25. The power circuit 23 may detect a malfunction of at least one IC by using a watchdog function or based on a state signal input from a separate monitoring device. If a malfunction of at least one IC is detected, the power circuit 23 may output a reset signal to the IC in which the malfunction is detected, thereby performing a function of resetting the corresponding IC.

The AFE IC 24 may be connected to the battery module 10 through the fastening device 30 and the interface circuit 21 to measure the state of the battery module 10, such as the cell voltage of battery cells included in the battery module 10. The AFE IC 24 may control the balancing circuit 22 to perform cell balancing between battery cells included in the battery module 10 based on the measured state of the battery module 10. The AFE IC 24 may communicate with a higher level controller or an external controller through the communication IC 25. In an implementation, the AFE IC 24 may transmit state information measured from the battery module 10 to a higher level controller or receive control information from the higher level controller through the communication IC 25.

The communication IC 25 may support wired or wireless communication between the AFE IC 24 and a higher level controller (or an external controller).

The AFE IC 24 and the communication IC 25 may receive an operation voltage from the power circuit 23. The AFE IC 24 and the communication IC 25 may be restarted in a reset state by power reset if the operation voltage supplied from the power circuit 23 is blocked for a predetermined time and then supplied again.

If a reset signal is received from the power circuit 23, the AFE IC 24 and the communication IC 25 may be reset and then restarted.

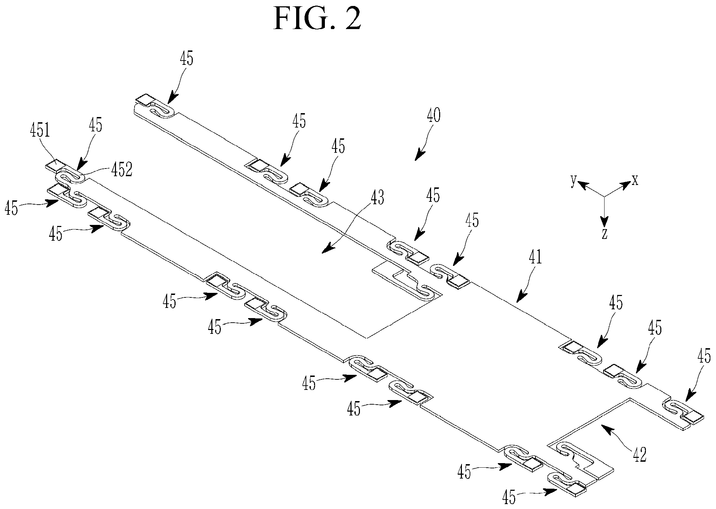

The management device 20 may further include a printed circuit board (PCB) (see reference numeral 40 in FIG. 2). That is, the management device 20 may be implemented in a form in which an electric circuit for implementing the aforementioned constituent elements, i.e., the interface circuit 21, the balancing circuit 22, the power circuit 23, the AFE IC 24, and the communication IC 25, may be mounted on the PCB 40.

FIG. 2 is an example of a PCB included in the management device 20 according to an embodiment.

Referring to FIG. 2, the PCB 40 may include a main board 41. The PCB 40 may further include openings 42 and 43 formed by removing a portion of a board material through milling or the like.

The PCB 40 may include a plurality of pad portions 45 outside the main board 41. Each pad portion 45 may include a connection portion 452 extending from the main board 41 and a conductive pad 451 formed on one surface of each connection portion 452. The conductive pad 451 may be formed on one surface of the connection portion 452 by using a conductive material such as nickel.

Each conductive pad 451 may be electrically connected to a battery cell included in the battery module 10 through the fastening device 30. Each conductive pad 451 may be electrically connected to an electrical circuit, e.g., the interface circuit 21, the balancing circuit 22, the power circuit 23, and the like, mounted on the PCB 40 through a wire formed on the PCB 40. In an implementation, each conductive pad 451 may function to transmit the voltage transmitted from the battery module 10 through the fastening device 30 to the electric circuit composing the management device 20.

The connection portion 452 may provide a flexible connection between the main board 41 and each conductive pad 451. In order to reduce mechanical stress transmitted to the main board 41 through each pad portion 45 in the process of fastening the PCB 40 to the fastening device 30, each connection portion 452 may include a meander-shaped or spring-like structure. Each connection portion 452 may be formed by removing a portion of an outer portion of a board material composing the PCB 40 through milling or the like. A wire or the like for providing an electrical connection between each conductive pad 451 and an electric circuit mounted on the PCB 40 may be formed in each connection portion 452.

The PCB 40 may be configured as a flexible PCB or FR-4 PCB.

Referring back to FIG. 1, the fastening device 30 may fasten or disconnect an electrical connection between battery cells included in the battery module 10 and the management device 20.

The fastening device 30 may be configured to fasten or disconnect the electrical connection between the battery module 10 and the management device 20 in a hook method without soldering or welding so as to facilitate not only electrical fastening but also electrical disconnection.

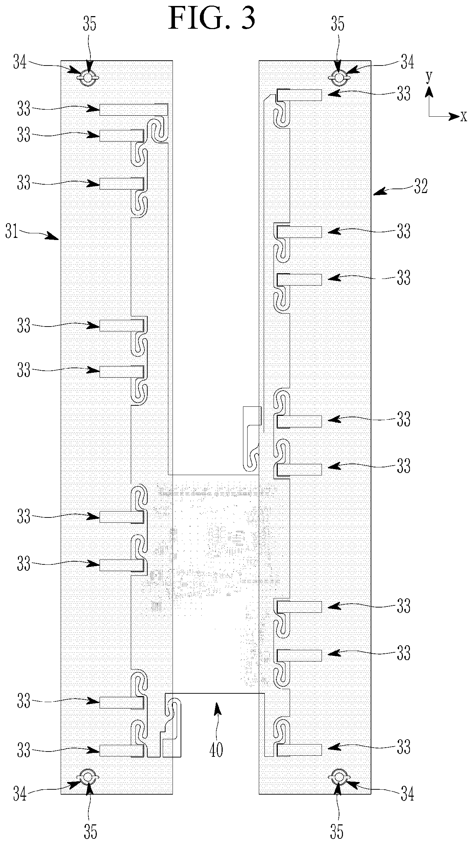

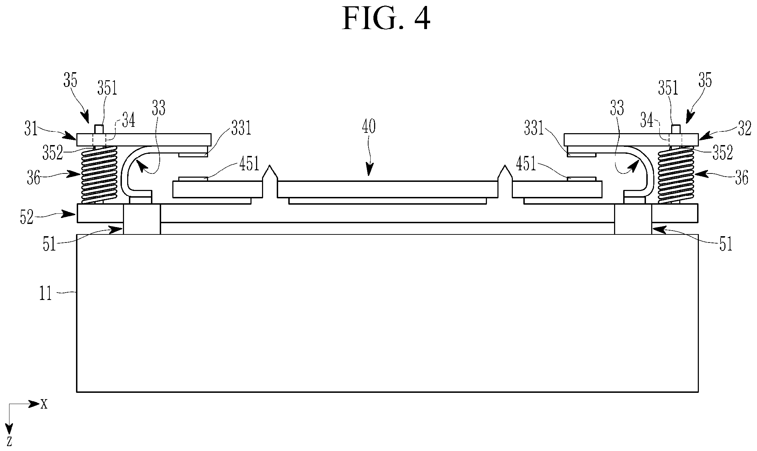

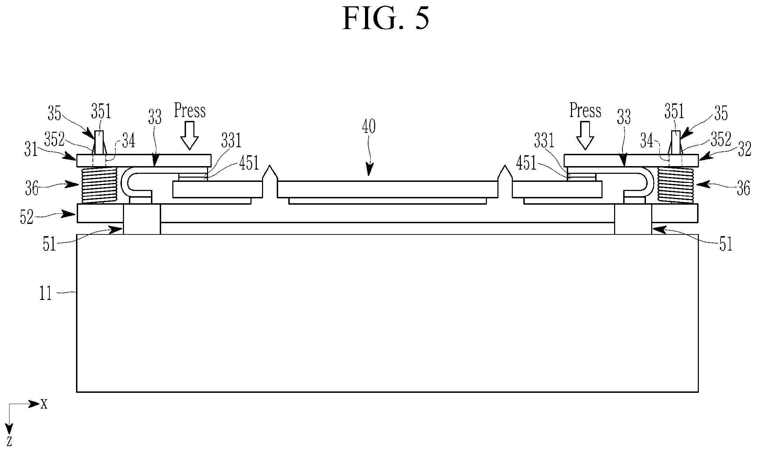

FIGS. 3 to 5 are drawings showing a method of fastening or disconnecting an electrical connection between the management device 20 and the battery module 10 using the fastening device 30 according to the embodiment. FIG. 3 is a drawing viewed from the top of the PCB 40 when the fastening device 30 and the PCB 40 of the management device 20 are fastened. FIG. 4 is a drawing viewed from the side of the PCB 40 when the electrical connection between the PCB 40 and the battery cells 11 of the management device 20 by the fastening device 30 is disconnected, and FIG. 5 is a drawing viewed from the side of the PCB 40 when the electrical connection between the PCB 40 and the battery cells 11 of the management device 20 is fastened by the fastening device 30.

Referring to FIG. 3 to FIG. 5, the fastening device 30 may include a plurality of substrates 31 and 32, a plurality of flexible connection PCBs 33 coupled to surfaces facing the PCB 40 in respective substrates 31 and 32, a plurality of fastening hooks 35, and a plurality of springs 36.

The substrates 31 and 32 may function to maintain the plurality of flexible connection PCBs 33 in contact with the PCB 40 of the management device 20 or to separate the plurality of flexible connection PCBs 33 from the PCB 40. The substrates 31 and 32 may be separated from the PCB 40 by pressing the plurality of flexible connection PCBs 33 to contact the PCB 40 or by moving the plurality of flexible connection PCBs 33 upward to separate from the PCB 40, in a state in which the PCB 40 of the management device 20 is fixed to the lower portions of the substrates 31 and 32. For example, as can be seen in Figs. 4 and 5, if substrates 31 and 32 are pressed towards the PCB 40 the plurality of flexible connection PCBs 33 may come into contact with the PCB 40. Additionally, if the substrates 31 and 32 are moved away from the PCB 40 the plurality of flexible connection PCBs 33 may separate from the PCB 40.

The fastening hooks 35 may be fastened to the corresponding substrates 31 and 32 and may fix the positions of the corresponding substrates 31 and 32 so that the plurality of flexible connection PCBs 33 remain in contact with the PCB 40 of the management device 20.

Each of the substrates 31 and 32 may include a plurality of fastening holes 34 into which the fastening hooks 35 may be inserted. The fastening hook 35 may operate in a hook manner so that the coupling with the substrates 31 and 32 can be easily fastened or disconnected. Each fastening hook 35 may include a fastening post 351 and an elastic hook 352 coupled to an outer circumferential surface of the fastening post 351.

One of both ends of the fastening post 351 may be coupled to a fixing structure maintaining a fixed position in the battery pack 1, and the other thereof may be inserted and coupled into the corresponding fastening hole 34. Referring to FIGS. 4 and 5 as an example, one end of each fastening post 351 may be fixedly coupled to an upper frame 52 (or holder bus bar assembly) included in a bus bar assembly of the battery pack 1. However, one end of the fastening post 351 may be coupled to another structure maintaining a fixed position, such as a bus bar.

If the fastening posts 351 corresponding to the respective fastening holes 34 of the substrates 31 and 32 are inserted, the substrates 31 and 32 may move in a vertical direction along the fastening posts 351. The elastic hook 352 may fix the positions of the substrates 31 and 32 into which the fastening posts 351 are inserted at a predetermined position or release the position fixation of the substrates 31 and 32.

A degree (that is, a protruding height) of the elastic hook 352 protruding from the outer surface of the fastening post 351 may vary according to pressure applied from the outside. In an initial state in which no pressure is applied, the elastic hook 352 may maintain an initial state of maximally protruding from the outer surface of the fastening post 351 by an elastic force. Referring to FIG. 4, the elastic hook 352 in the initial state may not pass through the fastening holes 34 of the substrates 31 and 32 due to its protruding height.

If pressure is applied to the elastic hook 352 in the initial state, the protruding height of the elastic hook 352 may decrease due to the pressure. The elastic hook 352 may be configured to have a triangular shape with a narrower width toward an upper side (that is, a non-fixed end side of the fastening post 351). Due to this structure, some of the pressure pressing the substrates 31 and 32 may be transmitted as a force opposite to the elastic force of the elastic hook 352. In an implementation, the protruding height of the elastic hook 352 may be reduced by the pressure pressing the substrates 31 and 32, so that the elastic hook 352 may pass through the fastening hole 34. If the elastic hook 352 completely passes through the fastening hole 34, the pressure applied to the elastic hook 352 by the pressure pressing the substrate 31 and 32 may be released, and the elastic hook 352 may be restored to its initial state by the elastic force. The elastic hook 352 restored to its initial state, as shown in FIG. 5, may operate as a stopper to fix the position of the substrates 31 and 32, thereby maintaining the fastening state between the substrates 31 and 32 and the fastening hook 35.

If pressure is applied to the elastic hook 352 while the substrates 31 and 32 are engaged with the fastening hook 35, the protruding height of the elastic hook 352 may decrease. If the protruding height of the elastic hook 352 decreases to such an extent that the elastic hook 352 may pass through the fastening hole 34, the position fixation by the elastic hook 352 may be released, and the substrates 31 and 32 may move upward. In an implementation, the cylindrical springs 36 respectively surrounding the fastening posts 351 may be disposed on the lower surfaces of the substrates 31 and 32. The springs 36 may respectively press the substrates 31 and 32 in an upward direction by an elastic force. In an implementation, if a worker presses the elastic hook 352 and the position fixation by the elastic hook 352 is released, the spring 36 may press the substrate 31 and 32, and the fastening state between the substrate 31 and 32 and the fastening hooks 35 may be released. Each spring 36 may have a larger diameter than the fastening hole 34 so that it cannot pass through the fastening hole 34.

A plurality of flexible connection PCBs 33 may be coupled to the lower surface of each of the substrates 31 and 32. In an implementation, as shown in FIG. 5, if the substrates 31 and 32 are fastened with the fastening hooks 35, the plurality of flexible connection PCBs 33 may be pressed downward by the substrates 31 and 32, so that the plurality of flexible connection PCBs 33 and the PCB 40 may come into contact. On the other hand, as shown in FIG. 4, if the fastening between the substrates 31 and 32 and the fastening hooks 35 is released, the plurality of flexible connection PCBs 33 may be moved upward by the substrates 31 and 32, so that the plurality of flexible connection PCBs 33 and the PCB 40 may be spaced apart from each other. The respective substrates 31 and 32 may simultaneously move the plurality of flexible connection PCBs 33 to contact or separate the plurality of flexible connection PCBs 33 to or from the PCB 40 simultaneously. In an implementation, the substrates 31 and 32 may reduce the number of repetitions of the fastening work between the flexible connection PCB 33 and the PCB 40. Meanwhile, in FIG. 3 to FIG. 5, a case in which the two substrates 31 and 32 are used to fasten or disconnect electrical connections between the plurality of flexible connection PCBs 33 and the PCB 40 is illustrated as an example, but the number of substrates may be more or less changed.

The substrates 31 and 32 may be configured as transparent substrates made of a transparent insulating material, such as transparent acrylic, so that the fastening state between the plurality of flexible connection PCBs 33 and the PCB 40 may be checked with the naked eye.

The plurality of flexible connection PCBs 33 may be for electrically connecting the conductive pads 451 of the PCB 40 and the battery cells 11. Each flexible connection PCB 33 may include an insulating substrate, a contact pad 331 formed on the insulating substrate, and a conductive wire electrically connected to the contact pad 331. Each flexible connection PCB 33 may be configured as a flexible PCB.

One end portion of each flexible connection PCB 33 may be coupled to a corresponding bus bar 51. Each flexible connection PCB 33 may be coupled to the bus bar 51 by using soldering, an anisotropic conductive film (ACF), or the like. In an implementation, each flexible connection PCB 33 (that is, the conductive wire of each flexible connection PCB 33) may be electrically connected to the bus bar 51.

The other end portions of each flexible connection PCBs 33 may be coupled to the bottom surfaces of the corresponding substrates 31 and 32. The respective flexible connection PCBs 33 may be attached to the lower surfaces of the corresponding substrates 31 and 32 by using an adhesive film, an adhesive, or the like. The contact pads 331 may be disposed on the lower surfaces of the end portion coupled to the substrates 31 and 32 in the respective flexible connection PCBs 33. The contact pad 331 is a pad for contacting the conductive pad 451 of the PCB 40. In an implementation, the positions at which the respective flexible connection PCBs 33 are coupled to the substrates 31 and 32 may be determined such that the contact pads 331 face the conductive pads 451. The contact pad 331 may be a conductive pad treated with carbon. In an implementation, if each contact pad 331 contacts a corresponding conductive pad 451, the contact pad 331 and the conductive pad 451 may be electrically connected to each other. In an implementation, the conductive pad 451 may be electrically connected to the flexible connection PCB 33 through the contact pad 331 and electrically connected to the corresponding bus bar 51 through the flexible connection PCB 33.

Each contact pad 331 may contact or be separated from the conductive pad 451 of the PCB 40 by the movement of the substrate 31 or 32. Referring to FIG. 4 as an example, if the fastening between the substrate 31 or 32 and the fastening hook 35 is released and the substrates 31 or 32 moves in an upward direction, the contact pad 331 may move away from the PCB 40 and may be spaced apart from the corresponding conductive pad 451. Referring to FIG. 5 as an example, if the substrate 31 or 32 and the fastening hook 35 are fastened and the substrate 31 or 32 moves in a downward direction, the contact pad 331 may contact the corresponding conductive pad 451 by pressing the substrate 31 or 32.

As described above, in the battery pack 1 according to the embodiment, the fastening device 30 for fastening the electrical connection between the battery module 10 and the management device 20 may operate in a hook manner without welding. Therefore, if power reset of the management device 20 is required, the electrical connection between the battery module 10 and the management device 20 may be disconnected with a simple manipulation, and the battery module 10 and the management device 20 may be electrically fastened through a simple manipulation even after resetting.

Electronic or electrical devices according to the embodiments of the present disclosure and/or other related devices or constituent elements may be realized by using appropriate hardware, firmware (e.g., an application-specific integrated circuit), software, or combinations of software, firmware, and hardware. In an implementation, various configurations of the above-noted devices may be positioned on one integrated circuit (IC) chip or an individual IC chip. In addition, various configurations of the above-noted devices may be realized on a flexible printed circuit film, a tape carrier package (TCP), a printed circuit board (PCB), or one substrate. The electrical or mutual connections described in the present specification may, e.g., be realized by the PCB, wires on different types of circuit carriers, or conductive elements. The conductive elements may, e.g., include metallization such as surface metallizations and/or pins, and may include conductive polymers or ceramics.

In addition, the various configurations of the devices may be performed by one or more processors so as to perform the above-described various functions, they may be performed in one or more computing devices, and they may be processes or threads for performing computer program instructions and interacting with other system constituent elements. The computer program instruction is stored in a memory realizable in a computing device using a standard memory device such as a random access memory (RAM). The computer program instruction may also be stored in a non-transitory computer readable medium such as a CD-ROM or a flash drive.

By way of summation and review, in general, a secondary battery cell may include an electrode assembly including a positive electrode, a negative electrode, and a separator interposed between the positive and negative electrodes; a case accommodating the electrode assembly; and an electrode terminal electrically connected to the electrode assembly. An electrolyte solution may be injected into the case to enable charging and discharging of the battery cell through an electrochemical reaction between the positive electrode, the negative electrode, and the electrolyte solution. A shape of the case, such as a cylindrical or rectangular shape, depends on the purpose of the battery cell.

The battery cells may be connected in series and/or in parallel to each other to configure a battery module with high energy density. A battery pack may include one or more of these battery modules according to required specifications.

The battery pack may include a battery management system (BMS) for monitoring, controlling, and/or setting the battery pack. Depending on its function, the BMS may include a battery system manager (BSM) that may operate as a master control device, a battery management module (BMM) that may operate as a slave control device, and a battery disconnect unit (BDU) that may block or allows connection between a battery pack and an external device. The BMM may measure and balances states (a voltage, a temperature, a current, and the like) of cells included in the battery module, and transmits state information and event occurrence information detected during this process to the BSM which is a master.

To this end, the BMM may be configured to include at least one IC, such as an analog front end (AFE) integrated circuit (IC), a communication IC, and the like. If an IC included in the BMM abnormally operates, a method of resetting the corresponding IC may be used to restore the corresponding IC to a normal state. Typically, this reset function may be implemented by a circuit configuration (e.g., a switching element (transistor and the like), a logic gate circuit, and the like) in the BMM. On the other hand, if an IC in the BMM is reset using the circuit configuration in the BMM, the corresponding IC may not be properly reset due to a malfunction of the reset function and often remains in a malfunction state.

The present disclosure has been made in an effort to provide a fastening device and a battery pack including the same that may forcibly reset power if a reset function of an IC included in a battery management system is not operated. According to the present disclosure, it may be possible to forcibly reset power if a reset function of an IC included a battery management system does not normally operate.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A fastening device (30) for a battery pack (1) that is configured to fasten an electrical connection between a battery module (10) and a circuit board managing the battery module (10), the fastening device (30) comprising:
a substrate (31, 32) including a plurality of fastening holes (34);
a plurality of connection circuit boards coupled to a surface of the substrate (31, 32) facing the circuit board and configured to electrically connect a battery module (10) to a circuit board when in contact with the circuit board; and
a plurality of fastening hooks (35) fastened to the plurality of fastening holes (34) that is formed to fix a position of the substrate (31, 32) so that the plurality of connection circuit boards come into contact with the circuit board,
wherein the plurality of connection circuit boards each respectively includes a first end portion configured to be electrically connected to the battery module (10), and a second end portion coupled to the substrate (31, 32) and configured to be electrically connected to the circuit board when in contact with the circuit board.

2. The fastening device (30) as claimed in claim 1, wherein:
the second end portion includes a contact pad (331) that is configured to contact a conductive pad (451) of the circuit board when each of the plurality of connection circuit boards contacts the circuit board, and
the contact pad (331) is electrically connected to the first end portion.

3. The fastening device (30) as claimed in claim 1 or 2, wherein:
each of the plurality of connection circuit boards is a flexible circuit board, and
the first end portion is separated from the substrate (31, 32).

4. The fastening device (30) as claimed in any of claims 1 to 3, wherein the first end portion is coupled to a bus bar (51) and configured to be electrically connected to a battery module (10) through the bus bar (51).

5. The fastening device (30) as claimed in any of the preceding claims, wherein each of the plurality of fastening hooks (35) includes:
a fastening post (351) including a first end portion configured to be coupled to a fixing structure having a fixed position in a battery pack (1) and a second end portion inserted into a corresponding fastening hole (34) among the plurality of fastening holes (34), and
an elastic hook (352) coupled to an outer surface of the fastening post (351) and having a variable protruding height by pressing.

6. The fastening device (30) as claimed in claim 5, wherein the elastic hook (352) has a shape with a width that becomes narrower as it approaches the second end portion of the fastening post (351).

7. The fastening device (30) as claimed in claim 5 or 6, wherein the elastic hook (352) protrudes so as not to pass through a corresponding fastening hole (34) in an unpressurized state, and if the substrate (31, 32) is in a state in which the fastening post (351) is inserted into the corresponding fastening hole (34), a protrusion height is reduced by a pressure of the substrate (31, 32), so that the elastic hook (352) passes through the corresponding fastening hole (34).

8. The fastening device (30) as claimed in claim 6 or 7, wherein the elastic hook (352) is configured to operate as a stopper that fixes a position of the substrate (31, 32) in a state in which the plurality of fastening hooks (35) are fastened to each fastening hole (34).

9. The fastening device (30) as claimed in any of claims 5 to 8, further comprising a cylindrical spring (36) surrounding the fastening post (351), the cylindrical spring (36) having a diameter greater than that of each of the plurality of fastening holes (34), and/or, wherein the first end portion of the fastening post (351) is configured to be coupled to a bus bar (51) of a battery pack (1).

10. The fastening device (30) as claimed in any of claims 5 to 9, wherein the first end portion of the fastening post (351) is configured to be coupled to an upper frame (52) of a battery pack (1).

11. The fastening device (30) as claimed in any of the preceding claims, wherein the substrate (31, 32) is a transparent substrate (31, 32).

12. A battery pack (1), comprising:
the fastening device (30) of any of the preceding claims;
a battery module (10) including a plurality of battery cells (11); and
a circuit board on which at least one integrated circuit, IC, a plurality of conductive pads (451), and a power circuit (23) supplying an operation voltage to the at least one IC by using a voltage input through the plurality of conductive pads (451) are mounted.

13. The battery pack (1) as claimed in claim 12, wherein the second end portion of each of the plurality of connection circuit boards are configured to be pressed by the substrate (31, 32) to come into contact with the plurality of conductive pads (451) if the plurality of fastening hooks (35) are fastened to the plurality of fastening holes (34).

14. The battery pack (1) as claimed in claim 12 or 13, wherein the circuit board includes a main board (41), and a plurality of connection structures providing a flexible connection between the plurality of conductive pads (451) and the main board (41).

15. The battery pack (1) as claimed in claim 14, wherein the plurality of connection structures are meander-shaped or spring-like structures formed by removing a portion of an outer portion of a board material composing the circuit board.
